Europäisches Patentamt

(19) European Patent Office

Office européen des brevets

(11) Numéro de publication : **0 264 415 B1**

(12) **FASCICULE DE BREVET EUROPEEN**

(45) Date de publication du fascicule du brevet :
27.03.91 Bulletin 91/13

(51) Int. Cl.⁵ : **H01L 29/743, H01L 27/08**

(21) Numéro de dépôt : **87902554.2**

(22) Date de dépôt : **22.04.87**

(86) Numéro de dépôt international :
**PCT/FR87/00135**

(87) Numéro de publication internationale :
**WO 87/06768 05.11.87 Gazette 87/24**

(54) **COMPOSANT SEMICONDUCTEUR DE PROTECTION CONTRE LES SURTENSIONS ET SURINTENSITES.**

(30) Priorité : 25.04.86 FR 8606029

(43) Date de publication de la demande :
27.04.88 Bulletin 88/17

(45) Mention de la délivrance du brevet :
27.03.91 Bulletin 91/13

(84) Etats contractants désignés :
DE IT NL

(56) Documents cités :
FR-A- 2 363 897
FR-A- 2 566 582
US-A- 3 577 046

(56) Documents cités :
Patent Abstracts of Japan, vol. 6, no. 81,
(E-107) (959) 19 May 1982 & JP A 5718358
Electronique et Microelectronique Industrielles, no. 152, March 1972 (Paris, FR), R. Pezzani
et al.: "Le darlistor, thyristor rapide de puissance à haut pouvoir de commutation", pages
31-35

(73) Titulaire : THOMSON-CSF
51, Esplanade du Général de Gaulle
F-92800 Puteaux (FR)

(72) Inventeur : BACUVIER, Pierre
La Croix Chauffour
F-37000 Luynes (FR)

(74) Mandataire : de Beaumont, Michel et al
1bis, rue Champollion
F-38000 Grenoble (FR)

EP 0 264 415 B1

Jouve, 18, rue Saint-Denis, 75001 PARIS

## Description

La protection des équipements électriques vis-à-vis des surtensions et surintensités d'origine atmosphérique a pris une importance considérable ces dernières années.

Les composants utilisés jusqu'à maintenant sont principalement des tubes à décharge gazeuse (parafoudres gazeux). Ils sont parfois assistés par des composants semiconducteurs qui compensent, pendant les premières microsecondes de la surcharge électrique, la faible rapidité d'amorçage des parafoudres gazeux.

On a cherché à remplacer complètement les parafoudres gazeux par des composants semiconducteurs capables d'assurer les mêmes tenues en tension avec une plus grande rapidité d'amorçage et, si possible, la même tenue en courant à encombrement identique. Les composants utilisés sont du type thyristor (pour une protection unidirectionnelle) ou du type triac (pour une protection bidirectionnelle), c'est-à-dire dés structures à quatre couches semiconductrices de types de conductivités alternés NPNP.

Ces composants ne comportent pas de gâchette; la mise en conduction s'effectue par mise en avalanche locale de la jonction entre les couches centrales de la structure, cette avalanche déclenchant la conduction de la structure à quatre couches d'abord localement dans une zone primaire d'amorçage puis dans tout le volume du composant au fur et à mesure que la zone d'amorçage se propage latéralement sur toute la surface active du dispositif.

Si cette zone primaire d'amorçage est insuffisante, on risque d'aboutir à une destruction du composant par une concentration de courant trop importante dans une section trop faible (la conduction de courant ne s'effectuant que dans la zone amorcée).

C'est le cas en particulier lorsque la surintensité appliquée au composant présente un front de montée d'abord insuffisamment raide puis beaucoup plus raide : le front de montée insuffisamment raide au départ ne facilite pas la répartition initiale de la zone primaire d'amorçage, de sorte que lorsque le front devient ensuite plus raide, le courant devient très élevé dans une zone encore insuffisamment étendue. La vitesse de propagation de la zone d'amorçage est de l'ordre de 50 microns par microsecondes et elle varie en fonction de l'allure de la surcharge et de la structure physique du dispositif.

Un but de la présente invention est de fournir une structure de composant de protection qui permette une propagation particulièrement efficace de la zone d'amorçage, et ce quelle que soit la forme du front de montée de la surcharge électrique dans les premières microsecondes de cette surcharge.

On parvient à ce résultat à l'aide de la structure suivante.

Le composant est constitué essentiellement par une superposition de couches semiconductrices de types de conductivité alternés qui sont respectivement, entre une première face principale et une deuxième face principale, une couche de cathode de type N, une couche de gâchette de type P, une couche centrale de type N et une couche d'anode de type P recouverte par une métallisation d'anode du côté de la deuxième face principale.

Selon l'invention,
– une première partie de la superposition de couches constitue un thyristor principal sans électrode de gâchette extérieure, la couche de cathode étant recouverte dans cette partie par une métallisation de cathode,
– une deuxième partie de la superposition de couches constitue un thyristor auxiliaire, la première face principale étant recouverte dans cette partie par une métallisation auxiliaire non connectée à la métallisation de cathode, cette métallisation auxiliaire recouvrant à la fois une portion de couche de cathode et une portion de couche de gâchette remontant jusqu'à la première face principale,
– une troisième partie de la superposition de couches constitue une diode zener en série avec une diode, la deuxième partie séparant zener étant constituée grâce à un accroissement local, dans la troisième partie, du dopage de l'un des côtés au moins de la jonction entre la couche de gâchette et la couche centrale.

De préférence, la troisième partie constituant une diode zener en série avec une diode est entièrement entourée par la deuxième partie formant thyristor auxiliaire, la deuxième partie étant elle-même complètement entourée par la première partie formant thyristor principal.

Selon une caractéristique de construction préférentielle, le composant est constitué par une juxtaposition de cellules, chaque cellule comprenant une partie formant diode zener entourée par une partie formant thyristor auxiliaire, elle-même entourée par une partie formant thyristor principal.

En ce qui concerne le thyristor auxiliaire, la métallisation auxiliaire est en contact avec une portion de couche de cathode et avec une portion de couche de gâchette, cette portion de couche de cathode étant de préférence située entre la portion de couche de gâchette et la troisième partie formant diode zener.

Le thyristor principal possède de préférence une structure avec des trous de "court-circuit" répartis sous la métallisation de cathode, trous par lesquels la couche de gâchette de type P remonte à travers)a couche de cathode de type N jusqu'à la métallisation de cathode.

Enfin, le composant selon l'invention peut être soit un composant de protection unidirectionnel de type thyristor sans gâchette, soit un composant de protection bidirectionnel de type triac sans gâchette. Dans ce dernier cas la structure comporte deux thyristors tête-bêche agencés chacun avec la structure spécifique selon l'invention. On notera que des composants d'allure similaire, sans diode zener mais avec gâchette, sont décrits dans le document Electronique et microélectronique industrielles, n°153, pages 31-35, 15 mars 1972, Paris FR, R. Pezzani et al.

D'autres caractéristiques et avantages de l'invention apparaitront à la lecture de la description détaillée qui suit et qui est faite en référence aux dessins annexés dans lesquels :

    – la figure 1 représente une coupe transversale d'un composant de protection selon l'invention,
    – la figure 2 représente un schéma électrique équivalent approximatif permettant d'expliquer le fonctionnement électrique de la structure selon l'invention,
    – la figure 3 représente une variante de réalisation sous forme cellulaire,
    – la figure 4 représente une vue de dessus correspondant à la figure 3,
    – la figure 5 représente une structure bidirectionnelle selon l'invention.

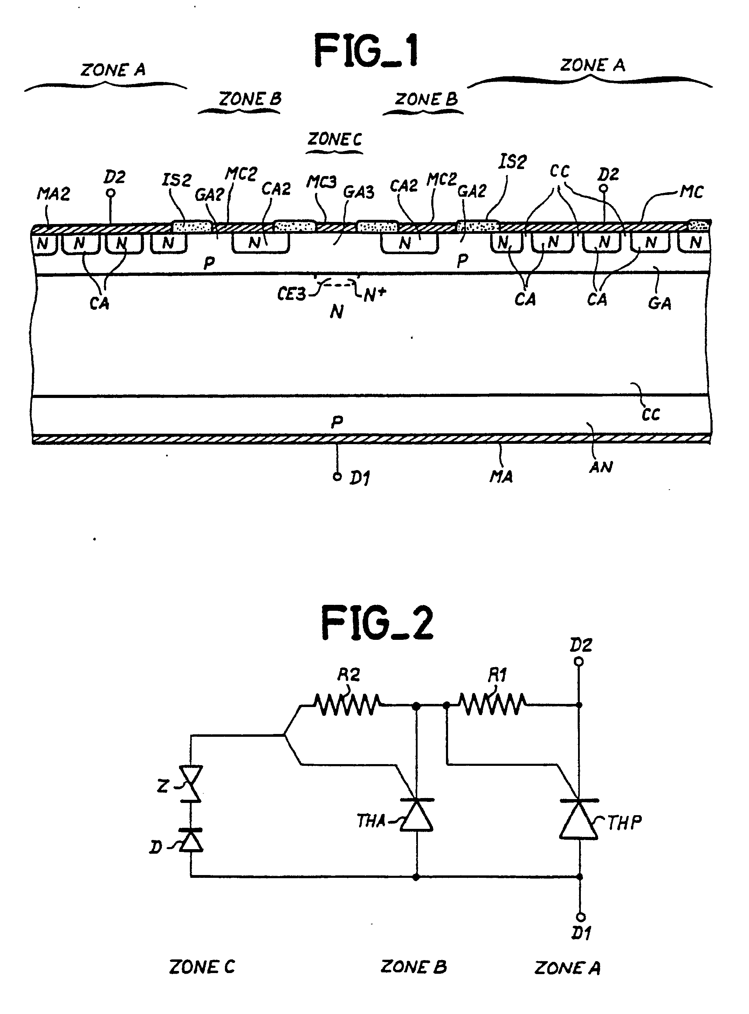

La coupe transversale de la figure 1 correspond à un composant de protection unidirectionnel, c'est-à-dire à une structure de type thyristor sans gâchette.

Le composant possède deux bornes de connexion extérieures et est destiné à être connecté par ces bornes entre deux points d'un circuit électrique à protéger contre des surtensions ou des surintensités pouvant provenir notamment de la foudre.

Ces bornes sont désignées par D1 et D2 et sont reliées électriquement, par un montage non représenté, à deux métallisations principales MA et MC recouvrant l'une la face inférieure et l'autre une partie de la face supérieure d'une tranche semiconductrice.

La tranche est constituée essentiellement d'un superposition de couches semiconductrices de types de conductivité alternés NPNP. Cette superposition comprend soit quatre couches, soit trois couches seulement à certains endroits.

Les couches sont respectivement, de bas en haut sur la figure 1, une couche d'anode AN de type P (qui est recouverte par la métallisation MA qu'on appellera métallisation d'anode), une couche centrale CE de type N, une couche de gâchette GA de type P (appelée ainsi par analogie avec la structure d'un thyristor, bien que le composant de protection soit ici dépourvu de borne de connexion extérieure vers cette couche de gâchette), et enfin une couche de cathode CA de type N partiellement recouverte par la métallisation MC appelée métallisation de cathode.

Pour la simplificationde la description, on désignera ci-après par couche de cathode toutes les couches de type N diffusées à partir de la surface supérieure dans la couche de gâchette sur une partie de la profondeur de cette dernière, bien que toutes les régions de type N ainsi diffusées ne jouent pas obligatoirement un rôle de "cathode" de thyristor.

Là où la couche de cathode est absente (absence de diffusion de type N dans la couche de gâchette), le composant est constituée par une superposition de trois couches alternées PNP.

Selon l'invention, la structure du composant se décompose en trois parties principales désignées sur la figure 1 par les appellations suivantes : zone A, zone B, zone C.

Ces zones sont de préférence disposées concentriquement, la zone A entourant la zone B qui entoure elle-même la zone C, de façon que la zone C soit partout séparée de la zone A par la zone B.

La zone A constitue un thyristor principal sans gâchette. Elle est en effet constituée par la superposition de quatre couches alternées AN, CE, GA, CA, la couche de cathode étant recouverte dans la zone A par la métallisation MC. On notera qu'on prévoit de préférence une structure de couche de cathode CA comportant dans la zone A des trous de court-circuit, parfois appelés aussi "court-circuit d'émetteur", qui sont des ouvertures dans la couche de cathode de type N par lesquelles la couche de gâchette de type P remonte jusqu'à la surface supérieure et se trouve en contact avec la métallisation de cathode MC. Les trous de court-circuit de la zone A sont désignés par la référence CC ; ce sont par exemple de petites ouvertures circulaires dans une couche qui est généralement de type N.

L'ensemble de la zone A constitue en soi un thyristor de protection sans gâchette. c'est le thyristor principal qui devra supporter le passage d'un courant important en cas de surcharge électrique entre les bornes du circuit que le composant doit protéger. La zone A occuppe donc en principe la majeure partie de la surface du composant.

La zone B est constituée de la manière suivante: elle comprend d'une part une superposition de quatre couches et d'autre part une superposition de trois couches ; en d'autres mots, la couche de cathode n'existe que dans une partie de la zone B, où elle est désignée par CA2 ; la couche de gâchette remonte à la surface dans le reste de la zone B, où elle est désignée par GA2. Plus précisément, la remontée GA2 de la couche de gâchette GA est située du côté de la zone A, tandis que la région CA2 de la couche de cathode est située de l'autre côté, c'est-à-dire du côté de la zone C qui est au centre de la structure concentrique. La couche de cathode CA2 sépare complètement la remontée GA2 de la zone C.

Il faut préciser encore que la remontée GA2 de couche de gâchette sépare complètement la région de cathode CA2 (appartenant à la zone B) de la région de cathode CA appartenant à la zone A.

Enfin, la zone B est recouverte, sur la face supérieure de la tranche semiconductrice, d'une métallisation auxiliaire MC2 qui est en contact à la fois avec la région CA2 et avec la région GA2 et qui est isolée électriquement de la métallisation de cathode MC du thyristor principal de la zone A, et qui n'est d'ailleurs raccordée à aucune autre borne extérieure du composant. L'isolation entre les métallisations MC et MC2 est faite par un diélectrique IS2.

La zone B constitue en fait un thyristor auxiliaire sans gâchette là où elle est constituée par une superposition de quatre couches, AN, CE, GA, CA2 ; ce thyristor auxiliaire devenant conducteur dans certaines conditions que l'on précisera plus loin.

Enfin, la zone C, au centre de la structure concentrique et complètement séparée de la zone A par la zone B, comprend une superposition de trois couches semiconductrices alternées PNP qui sont respectivement la couche d'anode AN, la couche centrale CE, et la couche de gâchette que l'on appellera GA3 dans cette zone et qui remonte jusqu'à la surface supérieure de la tranche semiconductrice (c'est-à-dire qu'il n'y a pas de portion de couche de cathode de type N dans cette zone A).

Cette superposition constitue électriquement un ensemble en série de deux diodes tête-bêche dont l'une est constituée par la jonction entre la couche d'anode AN et la couche centrale CE et l'autre par la jonction entre la couche centrale CE et la couche de gâchette GA. On donne à cette deuxième jonction une caractéristique de diode zener en accroissant localement le dopage de l'un au moins des côtés de la jonction (par rapport aux dopages de part et d'autre de cette jonction dans le reste de composant).

Dans l'exemple décrit plus précisément ici, on a prévu d'accroître le dopage de la couche centrale dans le zone C à proximité de la jonction entre couche centrale et couche de gâchette. La région surdopée de type $N^+$ qui en résulte est désignée par la référence CE3 dans la zone C.

Le dopage de la région CE3 est choisi tel que pour une tension dépassant un seuil prédéterminé entre les bornes extérieures D1 et D2 du composant la jonction CE3/GA3 se mette en avalanche, et ceci avant toute autre jonction polarisée en inverse du composant. La région CE3 peut être formée par une implantation initiale d'impuretés de type N prolongée par une diffusion conduisant à une profondeur suffisante pour que ces impuretés atteignent la couche centrale.

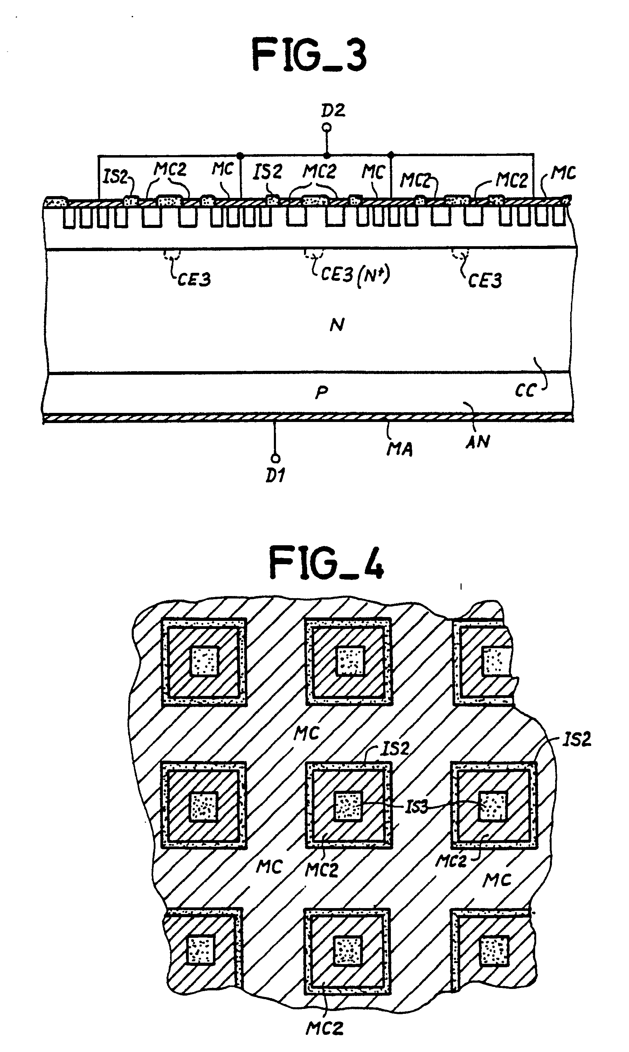

La couche de gâchette GA3 de la zone C peut être recouverte soit par une métallisation MC3 soit par un diélectrique. Si elle est recouverte par une métallisation, cette métallisation est isolée des autres métallisations (fig 1). Si elle est recouverte par un diélectrique 153 (figures 3,4,5), ce diélectrique recouvre toute la région GA3 au centre de la région CA2.

La figure 2 représente un schéma électrique qui en première approximation peut rendre compte du comportement électrique de la structure.

La zone A comprend une diode ordinaire D en série avec une diode zener Z.

La zone B comprend le thyristor auxiliaire THA et la zone C comprend le thyristor principal THP.

On a représenté en outre une résistance R1 entre la gâchette et la cathode du thyristor principal et une résistance R2 entre la gâchette et la cathode du thyristor auxiliaire.

En fait la gâchette du thyristor principal est constituée par la cathode du thyristor auxiliaire (c'est-à-dire pratique ment la métallisation auxiliaire MC2) ; la résistance R1 est la résistance de la région de gâchette de type P entre la métallisation auxiliaire MC2 et la métallisation de cathode MC.

De même la gâchette du thyristor auxiliaire est constituée par l'anode de la diode zener (c'est-à-dire la région GA3 ou la métallisation MC3) ; la résistance R2 est la résistance de la région de gâchette de type P entre cette anode et la métallisation auxiliaire MC2.

Selon l'invention on s'arrange pour que la résistance R2 soit largement supérieure à la résistance R1 pour que le thyristor auxiliaire se mette en conduction à partir d'un seuil de courant de gâchette (courant dans la résistance R2) beaucoup plus faible que le courant de gâchette (courant dans la résistance R1) du thyristor principal.

La résistance R2 est augmentée par accroissement de la distance physique entre l'anode de la diode zener et la zone de contact entre la métallisation auxiliaire et la région de gâchette GA2.

La résistance R1 peut être diminuée en prévoyant une courte distance entre la métallisation MC2 et les premiers trous de court-circuit CC du thyristor principal.

Le fonctionnement du composant est le suivant :
1) pour une tension entre les électrodes D1 et D2 inférieure à la tension de seuil de la diode zener Z, le composant est bloqué, toutes les jonctions du composant étant bloquées et présentant un faible courant de fuite,
2) lorsque la tension excède la tension de seuil de la diode zener, la jonction CE3/GA3 part en avalanche avec un courant inverse qui augmente rapidement,
3) dès que ce courant dépasse un certain seuil, qui dépend de la valeur de la résistance R2, le thyristor auxiliaire se déclenche ; en effet ce courant ne peut circuler qu'à travers la couche de gâchette située sous la couche d'anode CA2 du thyristor auxiliaire. Il constitue donc un véritable courant de gâchette pour ce thyristor auxiliaire et il permet donc de le déclencher. La résistance R1 étant plus faible que en R2, ce courant de gâchette ne déclenche pas la mise en conduction du thyristor principal bien qu'il constitue aussi un courant de gâchette pour le thyristor principal puisque ce courant s'écoule sous la couche de cathode CA vers les trous de court-circuit CC et vers la métallisation de cathode MC,

4) lorsque le thyristor auxiliaire se déclenche, il provoque le passage d'un courant élevé entre son anode et sa cathode ; ce courant passe de la couche CA2 vers la métallisation auxiliaire MC2 puis vers la couche de gâchette GA2 où il rejoint le courant de gâchette pour se diriger vers les trous de court-circuit CC et vers la métallisation de cathode MC du thyristor principal,

5) l'augmentation brutale de courant dans la région de gâchette du thyristor principal provoque alors une mise en conduction du thyristor principal. La résistance R1 est en effet suffisamment faible pour ne pas provoquer directement le déclenchement du thyristor principal lors du passage du courant de gâchette qui déclenche le thyristor auxiliaire, mais elle est suffisamment forte pour provoquer le déclenchement du thyristor principal lorsque c'est le courant du thyristor auxiliaire mis en conduction qui passe à travers R 1.

Dans ces conditions, non seulement la valeur du courant de gâchette du thyristor principal est suffisamment forte pour déclencher ce thyristor principal, mais la pente de croissance de ce courant de gâchette est extrêmement élevée (c'est la pente de croissance du courant entre les bornes d'un thyristor qui se déclenche) et cette pente très élevée est très favorable à l'obtention dans le thyristor principal d'une zone primaire d'amorçage large et se propageant rapidement dans toute la surface du thyristor principal.

Cet amorçage de bonne qualité se produit d'une manière quasi indépendante de la forme d'onde de la surtension qui se présente aux bornes du composant et c'est une des raisons de l'efficacité de la structure selon l'invention.

En effet, dans une structure différente, une surtension qui se présente avec une forme d'onde insuffisamment raide dans les premières microsecondes ne déclencherait pas de manière suffisamment uniforme et rapide le thyristor. Ici, même si le front de montée est insuffisamment raide, l'amorçage du thyristor principal se fait au moment du déclenchement du thyristor auxiliaire, et ce dernier produit de toutes façons un front de courant de gâchette très raide pour le thyristor principal.

La figure 3 représente une variante de réalisation de la structure de la figure 1, cette variante consistant en une disposition cellulaire du composant, chaque cellule ayant la même structure qu'à la figure 1 mais s'étendant sur une portion seulement du composant, des cellules adjacentes identiques ou semblables occupant le reste de la surface du composant.

Cette disposition cellulaire améliore encore l'amorçage du thyristor principal en cas de surtension.

La figure 4 représente une vue de dessus correspondant à la figure 3 montrant la disposition cellulaire des métallisations de cathode MC qui entourent les métallisations auxiliaires MC2, avec un isolement diélectrique IS2 entre les deux, c'est-à-dire autour de chaque métallisation auxiliaire, et un isolant IS3 au centre de chaque cellule.

On n'a pas représenté sur les figures 3 et 4 de métallisation supplémentaire au-dessus des zones de diode zener. S'il y en avait une, elle serait isolée des métallisations MC2, au centre de l'isolant 1S3.

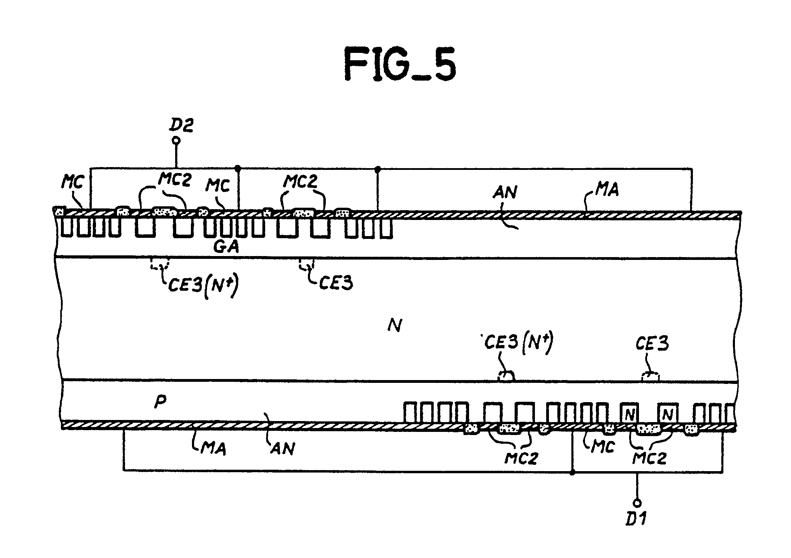

Enfin, la figure 5 représente une structure de composant bidirectionnel. Elle se déduit de la structure du composant de la figure 3 de la même manière qu'une structure de triac se déduit d'une structure de thyristor : le composant bidirectionnel comprend deux parties juxtaposées, chacune correspondant à un composant unidirectionnel, et ces parties sont placées tête-bêche, la couche de gâchette de l'une servant de couche d'anode pour l'autre, et la métallisation d'anode de l'une étant reliée à la métallisation de cathode de l'autre. Le dopage de la couche CE3 n'est pas forcément le même pour les deux parties de sorte que la tension d'amorçage d'un tel composant bidirectionnel n'est pas forcément la même pour des polarités opposées de tension appliquée au composant.

## Revendications

1. Composant semiconducteur à deux bornes pour la protection de circuits électriques contre des surtensions, constitué essentiellement par une superposition de couches semiconductrices de types de conductivité alternés qui sont respectivement, entre une première face principale et une deuxième face principale, une couche de cathode discontinue (CA) de type N, une couche de gâchette (GA) de type P, une couche centrale (CE) de type N, et une couche d'anode (AN) de type P recouverte par une métallisation d'anode (MA) reliée à une borne d'anode (D1) du côté de la deuxième face principale, caractérisé en ce que :

    – une première partie (zone A) de la superposition de couches constitue un thyristor principal sans électrode de gâchette extérieure, la couche de cathode (CA) étant recouverte dans cette partie par une métallisation de cathode (MC) reliée à une borne de cathode (D2),

    – une deuxième partie (zone B) de la superposition de couches constitue un thyristor auxiliaire, la première face principale étant recouverte dans cette partie par une métallisation auxiliaire (MC2) non connectée à la métallisation de cathode, cette métallisation auxiliaire recouvrant à la fois une portion de couche de cathode et une portion de couche de gâchette remontant jusqu'à la première face principale,

    – une troisième partie (zone C) de la superposition de couches, dans laquelle la couche de cathode est absente, constitue une diode zener en série avec une diode, la deuxième partie séparant complètement la première partie de la troisième partie, la diode zener étant constituée grâce à un accroissement local, dans la troisième partie, du dopage de l'un des côtés au moins de la jonction entre la couche de gâchette et la couche centrale.

2. Composant semiconducteur selon la revendication 1, caractérisé en ce que la partie constituant une diode zener en série avec une diode est entièrement entourée par la partie formant thyristor auxiliaire recouverte d'une métallisation auxiliaire (MC2), la partie formant thyristor auxiliaire étant elle-même complètement entourée par la partie formant thyristor principal recouverte par la métallisation de cathode (MC).

3. Composant semiconducteur selon la revendication 2, caractérisé en ce que le composant est réalisé sous forme d'un juxtaposition de cellules comprenant chacune une partie de diode zener complètement entourée par une partie de thyristor auxiliaire, elle-même complètement entourée par une partie de thyristor principal, les métallisations de cathode de toutes les parties de thyristor principal cellulaires étant réunies.

4. Composant semiconducteur selon l'une des revendications 1 à 3, caractérisé en ce que la métallisation auxiliaire (MC2) est en contact avec une portion de couche de cathode (CA2) et avec une portion de couche de gâchette (GA2), cette portion de couche de cathode (CA2) étant située entre cette portion de couche de gâchette (GA2) et la partie formant diode zener.

5. Composant semiconducteur selon l'une des revendications 1 à 4, caractérisé en ce que la couche de cathode du thyristor principal est pourvue de trous de court-circuit (CC) par lesquels la couche de gâchette remonte jusqu'à la métallisation de cathode (MC).

6. Composant semiconducteur selon l'une des revendication 1 à 5, caractérisé en ce que le composant est bidirectionnel et comporte sur le même substrat semiconducteur deux composants tête-bêche ayant chacun une structure selon l'une des revendications 1 à 5, la métallisation de cathode de l'un des composants étant reliée à la métallisation d'anode de l'autre.

**Ansprüche**

1. Halbleiterbauteil mit zwei Anschlüssen zum Schutz elektrischer Schaltkreise vor Überspannungen, im wesentlichen aufgebaut aus einer Übereinanderlagerung von Halbleiterschichten alternierender Leitungstypen, die jeweils zwischen einer ersten Hauptfläche und einer zweiten Hauptfläche liegen, einer diskontinuierlichen N-Typ-Kathodenschicht (CA), einer P-Typ-Gate-Schicht (GA), einer N-Typ-Zentralschicht (CE) und einer P-Typ-Anodenschicht (AN), die mit einem Anoden-Metallüberzug (MA) bedeckt ist, welcher auf der Seite der zweiten Hauptfläche mit einem Anodenanschluß (D1) verbunden ist, **dadurch gekennzeichnet, daß**

– ein erster Teil (Bereich A) der übereinandergelagerten Schichten einen Hauptthyristor ohne äußere GateElektrode bildet, wobei die Kathodenschicht (CA) in diesem Teil mit einem Kathoden-Metallüberzug (MC) bedeckt ist, welcher mit einem Kathodenanschluß (D2) verbunden ist,

– ein zweiter Teil (Bereich B) der übereinandergelagerten Schichten einen Hilfsthyristor bildet, wobei die erste Hauptfläche in diesem Bereich mit einem nicht mit dem Kathoden-Metallüberzug verbundenen Hilfs-Metallüberzug (MC2) bedeckt ist, welcher gleichzeitig einen Teil der Kathodenschicht und einen Teil der Gate-Schicht, die sich bis zur ersten Hauptschicht erstreckt, bedeckt,

– ein dritter Teil (Bereich C) der übereinandergelagerten Schichten, in dem die Kathodenschicht fehlt, eine Zener-Diode in Reihe mit einer Diode bildet, wobei der zweite Teil den ersten Teil vollständig vom dritten Teil trennt, wobei der Zener-Diode durch ein lokales Anwachsen, in dem dritten Teil, der Dotierung einer der Seiten wenigstens der Verbindungsstelle zwischen der Gate-Schicht und der Zentralschicht gebildet ist.

2. Halbleiterbauteil nach Anspruch 1, dadurch gekennzeichnet, daß der Teil, der eine Zener-Diode in Reihe mit einer Diode bildet, vollständig von dem Teil umgeben ist, der den mit einem Hilfs-Metallüberzug (MC2) versehenen Hilfsthyristor bildet, wobei der Teil, der den Hilfsthyristor bildet, selbst vollständig von dem Teil umgeben ist, der den mit einem Metallüberzug (MC) versehenen Hauptthyristor bildet.

3. Halbleiterbauteil nach Anspruch 2, dadurch gekennzeichnet, daß das Bauteil durch eine Nebeneinanderanordnung von Zellen aufgebaut ist, die jede einen Teil mit Zener-Diode aufweisen, vollständig umgeben von einem Teil mit Hilfsthyristor, der selbst vollständig von einem Teil mit Hauptthyristor umgeben ist, wobei die Kathoden-Metallüberzüge aller zellularen Teile mit Hauptthyristor miteinander verbunden sind.

4. Halbleiterbauteil nach einem der Ansprüche 1 bis 3, dadurch gekennzeichnet, daß der Hilfs-Metallüberzug (MC2) in Kontakt mit einem Teil der Kathodenschicht (CA2) und mit einem Teil der Gate-Schicht (GA2) ist, wobei dieser Teil der Kathodenschicht (CA2) zwischen diesem Teil der Gate-Schicht (GA2) und dem die Zener-Diode bildenden Teil angeordnet ist.

5. Halbleiterbauteil nach einem der Ansprüche 1 bis 4, dadurch gekennzeichnet, daß die Kathodenschicht des Hauptthyristors mit Kurzschluß-Löchern (CC) versehen ist, durch welche die Gate-Schicht sich bis zum Kathoden-Metallüberzug (MC) erstreckt.

6. Halbleiterbauteil nach einem der Ansprüche 1 bis 5, dadurch gekennzeichnet, daß das Bauteil bidirektional ist und auf demselben Halbleitersubstrat zwei "umgekehrte" Bauteile trägt, jedes mit einer Struktur nach einem der Ansprüche 1 bis 5, wobei der Kathoden-Metallüberzug des einen der Bauteile mit dem Anoden-Metallüberzug des anderen verbunden ist.

## Claims

1. A two-terminals semiconductor component for protecting electric circuit against overvoltages, formed essentially by a superimposition of semiconductive layers of alternate conductivity types which are respectively between a first main face and a second main face, an interrupted N-type cathode layer (CA), a P-type gate layer (GA), an N-type central layer (CE) and a P-type anode layer (AN) coated with an anode metallization (MA) connected to an anode terminal (D1) on the side of the second main face, characterized in this that :
   - a first part (zone A) of the superimposition of layers forms a main thyristor without external gate electrode, the cathode layer (CA) being coated in this part by a cathode metallization (MC) connected to a cathode terminal (D2),
   - a second part (zone B) of the superimposition of layers forms an auxiliary thyristor, the first main face being coated in this part by an auxiliary metallization (MC2) not connected to the cathode metallization, this auxiliary metallization covering both a cathode layer portion and a gate layer portion rising up to the first main face,
   - a third part (zone C) of the superimposition of layers from which the cathode layer is absent forms a Zener diode in series with a diode, the second part separating the first part completely from the third part, said Zener diode being formed by a local increase, in the third part, of the doping of one of the sides at least of the junction between the gate layer and the central layer.

2. A semiconductor component as claimed in claim 1, characterized in this that the part forming a Zener diode in series with a diode is entirely surrounded by the auxiliary thyristor part, covered with an auxiliary metallization (MC2), the auxiliary thyristor part being itself completely surrounded by the main thyristor part cove red by the cathode metallization.

3. A semiconductor component as claimed in claim 2, characterized in this that said component is formed by a juxtaposition of cells, each having a Zener diode part surrounded by an auxiliary thyristor part, itself surrounded by a main thyristor part, the cathode metallizations of all the cellular main thyristor parts being joined together.

4. A semiconductor component as claimed in any of claims 1 to 3, characterised in this that said auxiliary metallization (MC2) is in contact with a cathode layer portion (CA2) and with a gate layer portion (GA2), this cathode layer portion (CA2) being situated between said gate layer portion (GA2) and said Zener diode part.

5. A semiconductor components as claimed in any of claims 1 to 4, characterized in this that said cathode layer of the main thyristor is provided with "short circuit" holes (CC) through which the gate layer rises to the cathode metallization (MC).

6. A semiconductor component as claimed in any of claims 1 to 5, characterized in this that said component is bidirectional and includes on the same semiconductor substrate two head to tail components each having a structure such as claimed in one of claims 1 to 5, the cathode metallization of one of the components being connected to the anode metallization of the other.

# FIG_1

ZONE A  ZONE A

ZONE B  ZONE B

ZONE C

MA2  D2  IS2  GA2  MC2  CA2  MC3  GA3  CA2  MC2  GA2  IS2  CC  D2  MC

N N N N N N N N N N N N

P  P

CE3  N+  CA  CA  GA

N

CA

CC

P

D1  MA  AN

# FIG_2

R2  R1  D2

Z

D  THA  THP

ZONE C  ZONE B  ZONE A

D1

# FIG_3

# FIG_4

9

# FIG_5